# EUROPÄISCHE PATENTANMELDUNG

(11) **EP 1 391 741 A1**
(43) Veröffentlichungstag der Anmeldung: **25.02.2004**
(21) Anmeldenummer: 03017298.5
(22) Anmeldetag: 30.07.2003
(51) Int. Cl.: G01R 31/02

(54) **Verfahren zum Erkennen von Gefährdungen durch Streuströme**

(30) Priorität: 12.08.2002 DE 10236943
(71) Anmelder: SIEMENS AKTIENGESELLSCHAFT, 80333 München (DE)
(72) Erfinder: Altmann, Martin, 91054 Erlangen (DE); Braun, Wolfgang, 96110 Schesslitz (DE); Halfmann, Ulrich, 91094 Bräuningshof (DE); Schneider, Egid, Dr., 91085 Weisendorf (DE)

(57) **Zusammenfassung**

Die Erfindung betrifft ein Verfahren zum Erkennen von Gefährdungen durch Streuströme, die bei einer Bahnstrecke mit Gleichstromversorgung von der den Fahrstrom rückleitenden Fahrschiene zur Erde gelangen. Nach einer ersten Ausführung, bei der die Spannung zwischen Fahrschiene und Erde gemessen wird und beim Abweichen von einem Spannungsreferenzwert eine erhöhte Gefährdung durch Streuströme angezeigt wird, ist vorgesehen, dass die Spannung an mehreren Messstellen entlang der Bahnstrecke gemessen wird und dass die Messwerte in einer Auswertezentrale ausgewertet werden. Nach einer zweiten Ausführung ist vorgesehen, dass durch Aktivieren eines Kurzschließers ein Parallelweg zur Fahrschiene zum Rückleiten des Fahrstromes eingeschaltet wird. Die Stromstärke im Parallelweg wird dann gemessen und beim Abweichen von einem Stromstärkereferenzwert wird eine erhöhte Gefährdung durch Streuströme angezeigt. Besonders die gemeinsame Auswertung von mehreren Messwerten, die entlang der Bahnstrecke ermittelt wurden, ist für das Verfahren wichtig.

## Beschreibung

Die Erfindung betrifft Verfahren zum Erkennen von Gefährdungen durch Streuströme, nach den Oberbegriffen der Ansprüche 1 oder 2.

Solche Streuströme gelangen bei einer Bahnstrecke mit Gleichstromversorgung von der den Fahrstrom zurückleitenden Fahrschiene zur Erde (ins Erdreich).

Üblicherweise dienen bei Gleichstrombahnen die Fahrschienen zur Stromrückführung. Die Fahrschienen sind deshalb gegen Erde isoliert. Es soll nämlich kein Strom von den Fahrschienen aus durch die Erde in umliegende leitfähige Strukturen fließen. Solche Strukturen können Teile von Bauwerkfundamenten oder Tunnelanlagen sein, aber auch Rohrleitungssysteme. Durch den Stromfluss kann es an diesen Strukturen, sofern sie aus Metall bestehen, zu Korrosion kommen.

Die Isolation zwischen den Fahrschienen und Erde kann jedoch im Laufe der Zeit beschädigt oder auf andere Weise elektrisch überbrückt werden, so dass Streuströme zur Erde und zu den gefährdeten Strukturen gelangen könnten.

Um solche Streustromauswirkungen erkennen zu können, ist bereits vorgeschlagen worden, sogenannte Referenzelektroden entlang der Bahnstrecke zu installieren. Eine solche Elektrode misst das Potential in der Erde unter der Fahrschiene. Das Installieren solcher Elektroden ist sehr aufwändig. Darüber hinaus ist eine Auswertung der Messwerte der Elektroden kompliziert und kostspielig.

Es ist auch schon vorgeschlagen worden, mögliche Streuströme über besondere Einrichtungen, beispielsweise über Drainagedioden abzuleiten und diesen Strom bedarfsweise anzuzeigen.

Solche Konstruktionen führen zu einer dauernden Erhöhung der Streuströme.

Es wurde auch schon vorgeschlagen, an einer Stelle die Spannung zwischen Fahrschiene und Erde zu messen und beim Abweichen von einem Spannungsreferenzwert eine erhöhte Gefährdung durch Streuströme anzuzeigen.

Der Erfindung liegt die Aufgabe zugrunde, ein einfaches und zuverlässiges Verfahren zum Erkennen von Streustromgefährdungen anzugeben, das einfach auszuwertende Messwerte liefert und ohne aufwändige Einrichtungen auskommt und nicht zu einer dauerhaften Erhöhung der Streuströme führt.

Nach einer ersten Ausführung, bei der die Spannung zwischen Fahrschiene und Erde gemessen wird und beim Abweichen von einem Spannungsreferenzwert eine erhöhte Gefährdung durch Streuströme angezeigt wird, wird die Aufgabe dadurch gelöst, dass die Spannung an mehreren Messstellen entlang der Bahnstrecke gemessen wird und dass die Messwerte in eine Auswertezentrale übertragen und dort zentral ausgewertet werden.

Es wird der Vorteil erzielt, dass mehrere einfache Spannungsmesswerte ausreichen, um eine zuverlässige Aussage über die Gefährdung zu bekommen. Diese Spannungsmesswerte sind mit einfachen Spannungsmessgeräten an mehreren Messstellen zu ermitteln und können in einer Auswerteeinheit in einfacher Weise ausgewertet werden. Dabei erfolgt ein Vergleich mit Referenzwerten.

Nach einer zweiten Ausführung wird die Aufgabe dadurch gelöst, dass durch Aktivieren eines Kurzschließers ein Parallelweg zur Fahrschiene zum Rückleiten des Fahrstromes eingeschaltet wird, dass die Stromstärke im Parallelweg gemessen wird und dass beim Abweichen von einem Stromstärkereferenzwert eine erhöhte Gefährdung durch Streuströme angezeigt wird.

Ein solcher Parallelweg ist zum Beispiel eine durchgehende Tunnelarmierung. Er wird bei Bedarf über einen Kurzschließer angeschlossen.

Die zweite Ausführung des Verfahrens nach der Erfindung beinhaltet davon ausgehend die Erkenntnis, dass eine Stromstärkemessung im Parallelweg eine Beschädigung der Isolierung zwischen Fahrschiene und Erde anzeigen kann. Durch eine Beschädigung dieser Isolierung wird nämlich der elektrische Widerstand der Fahrschiene gegen Erde kleiner, so dass dort ein größerer Strom abfließt. Da der elektrische Widerstand des Parallelweges gleich bleibt, vergrößert sich infolge der Beschädigung der Isolierung die Stromstärke im Parallelweg.

Es wird der Vorteil erzielt, dass einfache Stromstärkemesswerte ausreichen, um eine zuverlässige Aussage über die Gefährdung zu bekommen. Es reichen einfache Strommessgeräte aus. Auch bei der zweiten Ausführung wird der Messwert zur Auswertung mit einem Referenzwert verglichen.

Mit beiden aufgezeigten Verfahren nach der Erfindung wird der Vorteil erzielt, dass Gefährdungen durch Streuströme schnell und zuverlässig mit einfachen technischen Mitteln zu erkennen sind. Eine Gefährdung von Strukturen in der Erde durch Streuströme kann durch frühzeitiges Ergreifen geeigneter Maßnahmen vermieden werden.

Bei der zweiten Ausführung des Verfahrens wird die Stromstärke beispielsweise an mehreren Messstellen entlang der Bahnstrecke gemessen und die Messwerte werden dann zentral ausgewertet. Damit wird der Vorteil erzielt, dass eine Ortung in einfacher Weise möglich ist.

Beispielsweise wird der Spannungs- oder Stromstärkereferenzwert bei neuwertiger Bahnstrecke und über einen Zeitraum mit bekannter Zugfolge ermittelt. Die späteren Messungen werden dann über einen weitgehend gleichlangen Zeitraum mit weitgehend gleicher Zugfolge durchgeführt. Dieser Zeitraum kann beispielsweise eine Woche lang sein.

Ein Stromfluss in den Fahrschienen ist nur dann gegeben, wenn die Bahnstrecke von Zügen befahren wird. Die Stromstärke des Rückstromes in der Fahrschiene hängt davon ab, welche Anzahl Züge auf der Strecke unterwegs ist und wie weit die einzelnen Züge von der Messstelle zum Zeitpunkt der Messung entfernt sind (Zugfolge). Es ist daher notwendig, sowohl die Referenzwerte als auch die späteren Messwerte über einen vorgegebenen gleichlangen Zeitraum zu mitteln, wobei darüber hinaus die Anzahl der Züge, die in diesen Zeitraum auf der Bahnstrecke unterwegs sind, möglichst gleich sein sollte.

Beispielsweise werden die Messwerte benachbarter Messstellen zusammen ausgewertet. Das kann durch Addition der Messwerte geschehen. Dadurch wird der Einfluss einzelner Fehlmessungen vermindert. Es ist eine Gesamtanalyse für eine verbesserte Überprüfung möglich.

Eine erhöhte Gefährdung wird beispielsweise für den Streckenabschnitt zwischen benachbarten Messstellen, die zusammen die größte Abweichung vom Referenzwert haben, angezeigt. Es ist also schnell und zuverlässig ein Ort anzugeben, an dem störende Streuströme auftreten, um gegebenenfalls die Isolierung zwischen Fahrschiene und Erde an dieser Stelle vor Ort überprüfen zu können.

Es kann auch beispielsweise angezeigt werden, dass der Ort mit der größten Gefährdung nahe an der Messstelle liegt, die den niedrigsten Messwert für die Spannung bzw. den höchsten Messwert für die Stromstärke liefert. Damit ist eine noch bessere Lokalisierung möglich.

Beispielsweise werden die Messwerte der einzelnen Messstellen entlang der Strecke über ein Kommunikationssystem zu einer Auswertezentrale übertragen. Das kann z.B. im Abstand von einer Sekunde geschehen.

Beispielsweise wird bei einem Abweichen vom Referenzwert um mindestens 50 % über einen Zeitraum von mehreren Tagen hintereinander eine Gefährdung angezeigt. Zum Beispiel beträgt dieser Zeitraum fünf Tage. Kurzzeitige außergewöhnliche Messwerte führen damit nicht zu einer Gefährdungsanzeige.

Beispielsweise wird beim Abweichen vom Referenzwert um zwischen 10 % und 50 % eine Möglchkeit für eine Gefährdung angezeigt. Man erhält somit einen Hinweis auf einen Ort, an dem eine Gefährdung möglicherweise auftreten könnte. Dieser Ort kann dann besonders beachtet werden.

Beispielsweise wird, wenn die Möglichkeit für eine Gefährdung über mindestens eine Woche, z.B. über zehn Tage hinweg, ununterbrochen angezeigt wird, das Vorhandensein einer Gefährdung angezeigt. Eine Abweichung vom Referenzwert zwischen z.B. 10 % und 50 % über einen relativ langen Zeitraum wird somit genauso wie eine größere aber kürzere Abweichung als Gefährdung angesehen.

Mit dem Verfahren nach der Erfindung wird insbesondere der Vorteil erzielt, dass Gefährdungen durch Streuströme, die von den Fahrschienen einer Gleichstrombahn ausgehen können, mit einfachen Mitteln schnell und zuverlässig sowohl erkannt als auch gegebenenfalls geortet werden können. Das Erkennen und/oder Orten erfolgt bei einer Spannungsmessung stets in einer zentralen Auswerteeinheit. Bei einer Stromstärkemessung ist das Erkennen und/oder Orten sowohl in einer zentralen Auswerteeinheit als auch lokal und autark sinnvoll möglich.

## Patentansprüche

1. Verfahren zum Erkennen von Gefährdungen durch Streuströme, die bei einer Bahnstrecke mit Gleichstromversorgung von der den Fahrstrom zurückleitenden Fahrschiene zur Erde gelangen, wobei die Spannung zwischen Fahrschiene und Erde gemessen wird und beim Abweichen von einem Spannungsreferenzwert eine erhöhte Gefährdung durch Streuströme angezeigt wird,
**dadurch gekennzeichnet, dass** die Spannung an mehreren Messstellen entlang der Bahnstrecke gemessen wird und dass die Messwerte in eine Auswertezentrale übertragen und dort zentral ausgewertet werden.

2. Verfahren zum Erkennen von Gefährdungen durch Streuströme, die bei einer Bahnstrecke mit Gleichstromversorgung von der den Fahrstrom zurückleitenden Fahrschiene zur Erde gelangen,
**dadurch gekennzeichnet, dass** durch Aktivieren eines Kurzschließers ein Parallelweg zur Fahrschiene zum Rückleiten des Fahrstromes eingeschaltet wird, dass die Stromstärke im Parallelweg gemessen und ausgewertet wird und dass beim Abweichen von einem Stromstärkereferenzwert eine erhöhte Gefährdung durch Streuströme angezeigt wird.

3. Verfahren nach Anspruch 2,
**dadurch gekennzeichnet, dass** die Stromstärke an mehreren Messstellen entlang der Bahnstrecke gemessen wird und dass die Messwerte zentral ausgewertet werden.

4. Verfahren nach einem der Ansprüche 1 oder 3,
**dadurch gekennzeichnet, dass** die Messwerte benachbarter Messstellen zusammen ausgewertet werden.

5. Verfahren nach einem der Ansprüche 1 bis 4,
**dadurch gekennzeichnet, dass** der Spannungs- oder Stromstärkereferenzwert bei neuwertiger Bahnstrecke und über einen Zeitraum mit bekannter Zugfolge ermittelt wird und dass die späteren Messungen über einen weitgehend gleichlangen Zeitraum mit weitgehend gleicher Zugfolge durchgeführt werden.

6. Verfahren nach einem der Ansprüche 1 oder 3 bis 5,
**dadurch gekennzeichnet, dass** eine erhöhte Gefährdung für den Streckenabschnitt zwischen benachbarten Messstellen, die die größte Abweichung vom Referenzwert haben, angezeigt wird.

7. Verfahren nach einem der Ansprüche 1 bis 6,
**dadurch gekennzeichnet, dass** angezeigt wird, dass der Ort mit der größten Gefährdung an oder nahe an der Messstelle liegt, die den niedrigsten Messwert für die Spannung / den höchsten Messwert für die Stromstärke liefert.

8. Verfahren nach einem der Ansprüche 1 bis 7,
**dadurch gekennzeichnet, dass** die Messwerte über ein Kommunikationssystem zu einer Auswertezentrale übertragen werden.
